# EUROPEAN PATENT APPLICATION

(11) **EP 4 845 362 A1**
(43) Date of publication of application: **25.11.2026**
(21) Application number: 25850050.3
(22) Date of filing: 09.05.2025
(51) Int. Cl.: H10K 30/50

(54) **BACK CONTACT CELL ASSEMBLY, PREPARATION METHOD THEREFOR, AND PHOTOVOLTAIC SYSTEM**

(30) Priority: 05.08.2024 CN 202411077547
(71) Applicant: Tianjin Aiko Solar Energy Technology Co., Ltd., Tianjin 300400 (CN); Zhejiang Aiko Solar Energy Technology Co., Ltd., Yiwu, Jinhua Zhejiang 322000 (CN); Zhuhai Fushan Aiko Solar Energy Technology Co., Ltd., FushanIndustrial Park, Doumen District Zhuhai Guangdong 519000 (CN); Shandong Aiko Solar Energy Technology Co., Ltd., Jinan, Shandong 250000 (CN); Chuzhou Aiko Solar Technology Co., Ltd., Chuzhou, Anhui 239514 (CN); Shenzhen Aiko Digital Energy Technology Co., Ltd., Shenzhen, Guangdong 518000 (CN); Guangdong Aiko Solar Energy Technology Co., Ltd., Foshan, Guangdong 528000 (CN)
(72) Inventor: XU, Zhigang, Jinhua, Zhejiang 322000 (CN); QIU, Xianqi, Jinhua, Zhejiang 322000 (CN); CHEN, Gang, Jinhua, Zhejiang 322000 (CN)
(74) Representative: EP&C
(86) International application number: PCT/CN2025/093983
(87) International publication number: WO 2026/031681

(57) **Abstract**

The disclosure provides a back contact cell module, a manufacturing method therefor, and a photovoltaic system. A rear side of a cell of the module is provided with a first doped layer and a second doped layer that extend along a first direction separately, a ribbon extending in a third direction is electrically connected to the first doped layer of the cell and a second doped layer of an adjacent cell separately, and an included angle between the first direction and the third direction is an acute angle.

## Description

### Cross-Reference to Related Application

The disclosure claims the priority to Chinese Patent Application No. 202411077547.1, filed with the China National Intellectual Property Administration on August 5, 2024 and entitled "Back contact cell module, manufacturing method therefor, and photovoltaic system", which is incorporated in its entirety herein by reference.

### Technical Field

The disclosure belongs to the technical field of solar cells, and particularly relates to a back contact cell module, a manufacturing method therefor, and a photovoltaic system.

### Background

Currently, a back contact cell is a solar cell with a light-facing surface free of electrodes and a light-sheltered surface equipped with positive and negative electrodes. Thus, the cell can be less sheltered by the electrodes, short-circuit currents of the cell can be increased, and energy conversion efficiency of the cell can be improved. However, in the prior art, the electrodes and ribbons of the back contact cell are provided on a rear side of the cell. Since the ribbons that expand when heated and contract when cooled are displaced with respect to the cell, the ribbons are likely to be broken or separated from the cell.

### Summary

The disclosure provides a back contact cell module, a manufacturing method therefor, and a photovoltaic system, so as to solve a problem that a ribbon is likely to be separated from a cell in a use process of a photovoltaic cell.

The back contact cell module provided in the disclosure includes a plurality of cell strings and ribbons. Each of the plurality of cell strings includes a plurality of cells, where each of the cells is provided with a front side and a rear side that are opposite, the rear side is provided with at least one first doped layer and at least one second doped layer, the first doped layers and the second doped layers extend along a first direction and are alternately distributed along a second direction, and the first direction intersects with the second direction; and each of the ribbons are provided on at least two of the plurality of cells and electrically connected to the first doped layers of the cell and the second doped layers of the adjacent cell separately, the ribbons extend in a third direction and alternately distributed along the second direction, and an included angle between the first direction and the third direction is an acute angle; and a doping polarity of the first doped layers and a doping polarity of the second doped layers are opposite.

In some examples, the included angle α between the first direction and the third direction satisfies the following relational expression: 0<tanα≤D/L, where
L is a total length between a distal point of a first cell and a distal point of a last cell in the cell string along the first direction, and D is a width of any doped layer of the cells along the second direction.

In some examples, a width of each of the first doped layers in the second direction is equal to a width of each of the second doped layers in the second direction .

In some examples, center distances of two adjacent ribbons are equal in the second direction;
center distances of two adjacent doped layers are equal; and
the center distances of the two adjacent doped layers are equal to the center distances of the two adjacent ribbons.

In some examples, the rear side is provided with first grid lines and second grid lines, the first grid lines and the second grid lines extend along the first direction and are alternately distributed along the second direction, the first grid lines are provided on the first doped layers, the second grid lines are provided on the second doped layers, and each of the plurality of ribbons covers a first grid line of each cell and a second grid line of an adjacent cell.

In some examples, center distances of two adjacent grid lines are equal; and
the center distances of the two adjacent grid lines are equal to center distances of two adjacent ribbons.

In some examples, the plurality of the ribbons are arranged in parallel; and
the first grid lines, the second grid lines, the first doped layers and the second doped layers are all arranged in parallel.

In some examples, each of the plurality of ribbons includes a first side and a second side, each of the first side and the second side extends in the third direction, the first side includes a start section and a tail section on any of the cells, and a distance between each of the grid lines and the start section is greater than a distance between the grid line and the tail section.

In some examples, each of the cells is rectangular in shape, the cells include first cells and second cells sequentially provided in the first direction, the cells include first edges and second edges distributed along the second direction, grid lines of the first cells closest to the first edges are the first grid lines, and grid lines of the second cells closest to the first edges are the second grid lines.

In some examples, each of the plurality of ribbons is elongated in shape, and a width of the ribbon is less than a distance between the first grid line and the second grid line.

In some examples, the ribbons include first ribbons and second ribbons, and each of the first ribbons and each of the second ribbons extend along the third direction and are alternately distributed along the second direction;
each of the first ribbons covers and is connected to the first doped layer or the first grid line of the first cell and the second doped layer or the second grid line of the second cell; and
each of the second ribbons covers and is connected to the second doped layer or the second grid line of the first cell and the first doped layer or the first grid line of another second cell.

In some examples, a distance between the start section and the first edge of each of the cells is less than a distance between the tail section and the first edge of each of the cell.

In some examples, the first edge of each of the cells is parallel to the doped layer or the grid line.

The disclosure provides a manufacturing method for a back contact solar cell module. The manufacturing method includes:
providing a plurality of cells in a first direction to form an array of cell strings;
laying ribbons on rear sides of the cells in a third direction, where each of the plurality of ribbons is elongated in shape and at least partially covers one doped layer of the cells or one grid line provided on the doped layer, and an included angle between the first direction and the third direction is an acute angle;
breaking the ribbons at predetermined positions;
providing back adhesive films and back sheets on one sides of the cells provided with the ribbons, and forming to-be-laminated parts; and
framing and mounting the to-be-laminated parts, welding a junction box, and forming a back contact solar cell module.

The photovoltaic system provided in the embodiments of the disclosure includes the back contact cell module of any of the above embodiments.

According to the back contact cell module provided in the embodiments of the disclosure, the back contact cell module includes the cell strings and the ribbons. The cell string includes the plurality of cells. Each of the cells is provided with a front side and a rear side that are opposite. The rear side is provided with the first doped layers and the second doped layers. The first doped layers and the second doped layers extend along the first direction and are alternately distributed along the second direction. The first direction intersects with the second direction. The ribbons are provided on at least two of the plurality of cells and electrically connected to the first doped layers of the cell and the second doped layers of the adjacent cell separately. The ribbons extend in the third direction and alternately distributed along the second direction. The included angle between the first direction and the third direction is an acute angle. Doping polarities of the first doped layers and the second doped layers are opposite. Accordingly, the ribbons and the doped layers can be arranged at acute angles, thus contact areas between the ribbons and the cells can be increased, electrical contact areas between the ribbons and the doped layer can be further increased, and electric conduction efficiency from the doped layers to the ribbons can be improved. Moreover, setting the ribbons obliquely can alleviate a problem of stress concentration, so as to guarantee stable connection between the ribbons and the cells.

### Brief Description of the Drawings

Fig. 1 is a schematic structural diagram of a part of a plane of a back contact solar cell module according to an example of the disclosure;
Fig. 2 is a schematic structural diagram of another part of a plane of a back contact solar cell module according to an example of the disclosure;
Fig. 3 is a schematic structural diagram of modules of a back contact solar cell module according to an example of the disclosure;
Fig. 4 is a schematic structural diagram of yet another part of a plane of a back contact solar cell module according to an example of the disclosure;
Fig. 5 is a schematic structural diagram of still another part of a plane of a back contact solar cell module according to an example of the disclosure;
Fig. 6 is a flowchart of a manufacturing method for a back contact solar cell module according to an example of the disclosure; and
Fig. 7 is a schematic structural diagram of a photovoltaic system according to an example of the disclosure.

### Reference numerals:

back contact cell module 100, rear side 12, first grid line 121, second grid line 122, first doped layer 123, second doped layer 124, first edge 13, second edge 14, first cell 101, second cell 102, first ribbon 21, second ribbon 22, first side 23, start section 231, tail section 232, second side 24, cell string 200, and photovoltaic system 300.

### Detailed Description of the Embodiments

In order to make the objectives, technical solutions, and advantages of the disclosure clearer, the disclosure will be further described in detail below with reference to the accompanying drawings and examples. The examples are illustratively shown in the accompanying drawings. The same or similar reference numerals denote the same or similar elements or elements having the same or similar functions throughout. The examples described below by reference to the drawings are illustrative for explaining the disclosure merely and are not to be construed as limiting the disclosure. Moreover, it should be understood that the specific examples described herein are merely used to explain the disclosure and are not intended to limit the disclosure.

In the description of the disclosure, it should be understood that the orientation or position relations indicated by the terms "length," "width," "up," "down," "left," "right," "horizontal," "top," "bottom," etc. are based on the orientation or position relations shown in the accompanying drawings, are merely for facilitating the description of the disclosure and simplifying the description, rather than indicating or implying that the device or element referred to must have a particular orientation or be constructed and operated in a particular orientation, and therefore cannot be interpreted as limiting the disclosure.

Moreover, the terms "first" and "second" are merely for description and cannot be interpreted as indicating or implying relative importance or implicitly indicating the number of technical features indicated. Thus a feature limited by "first" or "second" can explicitly or implicitly include one or more of the features. In the description of the disclosure, unless otherwise definitely and specifically defined, "a plurality" means two or more.

In the description of the disclosure, it should be noted that unless otherwise explicitly specified and limited, the terms "mount," "connect," and "connection" should be understood in a broad sense. For example, they can denote a fixed connection, a detachable connection, an integrated connection, a mechanical connection, an electric connection, mutual communication, a direct connection, an indirect connection via an intermediate medium, communication inside two elements, or an interaction relation of two elements. For those of ordinary skill in the art, the specific meanings of the above terms in the disclosure can be understood according to specific circumstances.

In the disclosure, a first feature is "on" or "underneath" a second feature can include that the first feature and the second feature are in direct contact, or in indirect contact through their another feature unless explicitly specified and limited otherwise. Moreover, the first feature is "on," "above" and "over" the second feature includes that the first feature is exactly above the second feature or not, or merely indicates that the first feature has a higher level than the second feature. The first feature is "underneath," "below" and "under" the second feature includes that the first feature is exactly below the second feature or not, or merely indicates that the first feature has a lower level than the second feature.

The following disclosure provides various different examples or instances configured to implement different structures of the disclosure. Components and configurations in specific instances are described below, in order to simplify the contents of the disclosure. Certainly, the components and configurations are merely illustrative and are not intended to limit the disclosure. Moreover, the disclosure can repeat the reference numerals and/or reference letters in different instances. Such repetition is configured for simplicity and clarity and does not indicate a relation between various examples and/or configurations discussed in itself. Moreover, the disclosure provides instances of various specific processes and materials, but those of ordinary skill in the art can recognize applications of other processes and/or use scenarios of other materials.

In the related art, a solar cell is a semiconductor device that directly converts energy of sunlight into electrical energy. The solar cell uses a photovoltaic effect to excite electrons by absorbing photons and output the electrons to generate an electric current through a built-in electric field. A back contact cell is a solar cell with a light-facing surface free of electrodes and a light-sheltered surface equipped with positive and negative electrodes. Thus, the cell can be less sheltered by the electrodes, short-circuit currents of the cell can be increased, and energy conversion efficiency of the cell can be improved. However, in the prior art, the electrodes and ribbons of the back contact cell are provided on a rear side of the cell. Since the ribbons that expand when heated and contract when cooled are displaced with respect to the cell, the ribbons are likely to be broken or separated from the cell. In embodiments of the disclosure, the ribbons and the doped layers can be arranged at acute angles, thus contact areas between the ribbons and the cells can be increased, electrical contact areas between the ribbons and the doped layer can be further increased, and electric conduction efficiency from the doped layers to the ribbons can be improved. Moreover, setting the ribbons obliquely can alleviate a problem of stress concentration, so as to guarantee stable connection between the ribbons and the cells.

### Embodiment 1

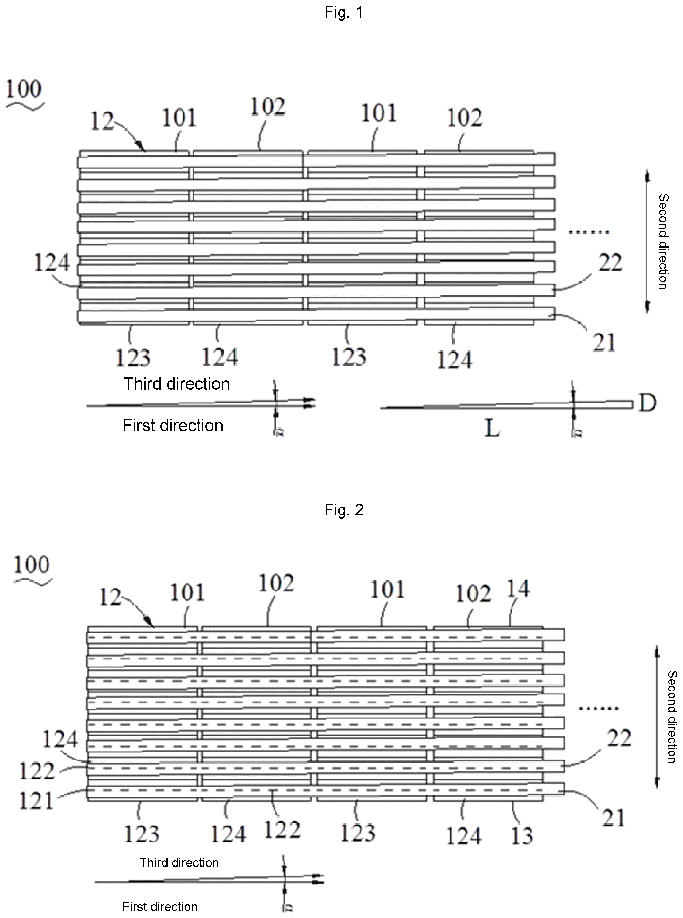

With reference to Fig. 1, Fig. 2 and Fig. 3, a back contact solar cell module 100 provided in the disclosure includes a plurality of cell strings 200 and ribbons (not labeled in the figures). The cell string 200 includes a plurality of cells (not labeled in the figures). Each of the cells is provided with a front side and a rear side 12 that are opposite. The rear side 12 is provided with first doped layers 123 and second doped layers 124. The first doped layers 123 and the second doped layers 124 extend along a first direction and are alternately distributed along a second direction. The first direction intersects with the second direction. The ribbons are provided on at least two of the plurality of cells and electrically connected to the first doped layers 123 of the cell and the second doped layers 124 of the adjacent cell separately. The ribbons extend in a third direction and alternately distributed along the second direction. The included angle between the first direction and the third direction is an acute angle. Doping polarities of the first doped layers 123 and the second doped layers 124 are opposite.

As shown in Fig. 1 and Fig. 2, in some optional embodiments, the cells include first cells 101 and second cells 102 sequentially provided in the first direction.

As shown in Fig. 2, in some optional embodiments, grid lines are provided on the rear sides of the cells. The grid lines include first grid lines 121 and second grid lines 122. The first grid lines 121 are provided on the first doped layers 123. The second grid lines 122 are provided on the second doped layers 124. The first grid lines 121 and the second grid lines 122 extend along the first direction and are alternately distributed along the second direction.

As shown in Fig. 2, in some optional embodiments, the ribbons include first ribbons 21 and second ribbons 22. The first ribbons 21 and the second ribbons 22 extend in the third direction and are alternately distributed along the second direction.

According to the back contact cell module 100 provided in the embodiments of the disclosure, the back contact cell module 100 includes the cell strings 200 and the ribbons. The cell string 200 includes the plurality of cells. Each of the cells is provided with a front side and a rear side 12 that are opposite. The rear side 12 is provided with the first doped layers 123 and the second doped layers 124. The first doped layers 123 and the second doped layers 124 extend along the first direction and are alternately distributed along the second direction. The first direction intersects with the second direction. The ribbons are provided on at least two of the plurality of cells and electrically connected to the first doped layers 123 of the cell and the second doped layers 124 of the adjacent cell separately. The ribbons extend in the third direction and alternately distributed along the second direction. The included angle between the first direction and the third direction is an acute angle. Doping polarities of the first doped layers 123 and the second doped layers 124 are opposite. Accordingly, the ribbons and the doped layers can be arranged at acute angles, thus contact areas between the ribbons and the cells can be increased, electrical contact areas between the ribbons and the doped layer can be further increased, and electric conduction efficiency from the doped layers to the ribbons can be improved. Moreover, setting the ribbons obliquely can alleviate a problem of stress concentration, so as to guarantee stable connection between the ribbons and the cells. Thus connection stability of the ribbons and the cells is improved.

In the example, the front sides of the cells are used for receiving light. The rear sides 12 of the cells include the plurality of first doped layers 123 and second doped layers 124 alternately arranged. The first doped layers 123 and the second doped layers 124 extend along the first direction to form a photocurrent.

Specifically, a first doped layer 123 of each of the cells and a second doped layer 124 of an adjacent cell can be connected together through a ribbon. A second doped layer 124 of the cell and a first doped layer 123 of another adjacent cell can be connected together through a ribbon. That is, the plurality of cells can be connected together in series through the ribbons, so as to form the cell strings 200 distributed along the first direction. Certainly, in some embodiments, a ribbon at an end of each of the cell strings 200 can be connected to only one doped layer and extend out of the cells to be connected to a bus bar or the like.

It can be understood that in the cell string 200, the cell string 200 can include two cells connected in series, three cells connected in series, or more cells connected in series. Specifically, the number of cells to be connected in series can be determined according to actual use conditions. Moreover, in the example of the disclosure, sizes and types of the cells are not limited. Specifications and sizes of adjacent cells can be the same or not, to satisfy different requirements.

In the embodiments of the disclosure, a specific arrangement method of the adjacent cells is not limited to satisfy different requirements. In one example, edges of two adjacent cells are at least partially stacked together. In another example, two adjacent cells can be spaced apart. A gap between the two adjacent cells is in a proper range, such that small operation space and high welding difficulty caused by a too small gap can be avoided, and waste of assembly space and cost increase caused by a too large gap can be avoided.

In the embodiments of the disclosure, doping types of the first doped layers 123 and the second doped layers 124 are not limited. For example, the first doped layers 123 and the second doped layers 124 can be P-type doped layers and N-type doped layers respectively. Alternatively, the first doped layers 123 can be N-type doped layers, and the second doped layers 124 can be P-type doped layers, as long as polarities of the first doped layers and the second doped layers are opposite each other to satisfy different requirements. In some examples, the first doped layers 123 can be P-type polysilicon layers, P-type amorphous silicon layers, or P-type microcrystalline silicon layers, which are not limited herein. Similarly, the second doped layers 124 can be N-type polysilicon layers, N-type amorphous silicon layers, or N-type microcrystalline silicon layers, which are not limited herein. When the first doped layers 123 are P-type doped layers, and the second doped layers 124 are N-type doped layers, P-type grid lines can be provided on the first doped layers 123 correspondingly, and N-type grid lines can be provided on the second doped layers 124 correspondingly, which are not limited herein.

In some examples, P-type doped refers to doped with Group III elements, including boron, aluminum, gallium, indium, thallium and other elements; and N-type doped refers to doped with Group V elements, including nitrogen, phosphorus, arsenic, antimony, bismuth and other elements, which are not limited herein.

Moreover, in some embodiments, the first doped layers 123 and the second doped layers 124 can also be in a compound doped type, for example, the N-type doped can also include a small amount of P-type doping elements. The second doped layers 124 have a content of N-type doping elements greater than 20% of a content of P-type doping elements, so as to guarantee a polarity being opposite that of the first doped layers 123.

In the back contact cell module 100 of the embodiment of the disclosure, the first direction and the second direction can be vertical directions. In this case, the cells can be rectangular in shape. The first direction and the second direction can also be edge directions of the cells, so as to maximize use of areas of the cells. The ribbons are provided on at least two cells in the third direction and electrically connected to the first doped layer 123 of the cell and a second doped layer 124 of the adjacent cell separately. The ribbons are alternately distributed along the second direction, to connect the doped layers of adjacent cells with opposite polarities to form the cell string 200. An included angle between the first direction and the third direction is an acute angle. By providing the ribbons and the doped layers at an acute angle, the contact areas between the ribbons and the cells are obviously increased, such that the electrical contact areas between the ribbons and the doped layers are improved, and the electric conduction efficiency is enhanced. Moreover, the inclined design of the ribbons can effectively alleviate the problem of stress concentration, so as to guarantee the stability of the connection between the ribbons and the cells, and reduce a connection failure caused by mechanical stress or temperature change. The strong connection between the ribbons and the doped layers guarantees stable electrical connection between the cells, and improves reliability and service life of the back contact cell module 100.

In the back contact cell module 100 according to the embodiment of the disclosure, the ribbons and the doped layers are actively arranged at an acute angle, such that process difficulty of the back contact cell module 100 can be reduced. Alignment requirements in a welding process can be reduced. A fault tolerance rate and accuracy of welding can be improved. Manufacturing complexity can be reduced. The inclined setting manner more facilitates operation of automatic apparatuses. Production efficiency is improved. Manual intervention is reduced. Production cost is reduced. The design of ribbons at an acute angle helps to disperse mechanical stress, reduce stress concentration of welding joints, and improve reliability and durability of the welding joints.

In the embodiment of the disclosure, a type of the cells is not limited to satisfy different requirements. For example, the cells can be of a type without grid lines, where current conduction is achieved by direct connection of the ribbons to the doped layers. Furthermore, in the embodiment of the disclosure, the doped layers of the cells have the same width in the second direction.

It can be understood that in such an example, the back contact cell module 100 can further include a frame, a back sheet, photovoltaic glass, and an adhesive film. The adhesive film can fill gaps between a front side and the rear side 12 of the cell, the photovoltaic glass, adjacent cells, etc. As a type of filler, the adhesive film can be a transparent adhesive having desirable light transmission performance and aging resistance. For example, the adhesive film can be a polyethylene vinylacetate (EVA) adhesive film or a polyethylene-1-octene (POE) adhesive film, which can be specifically selected according to an actual situation and will not be limited herein.

The photovoltaic glass can cover the adhesive film on the front side of each of the cells. The photovoltaic glass can be ultra-clear glass having high transmittance, high transparency, and excellent physical, mechanical, and optical properties. For example, the ultra-clear glass can have the transmittance of 92% or higher and protect the cell without affecting the efficiency of the cell as much as possible. Moreover, the photovoltaic glass can adhere to the cell through the adhesive film. The adhesive film can seal, insulate, and waterproof the cell.

The back sheet can adhere to the adhesive film on the rear side 12 of the cell to protect and support the cell, and has the reliable insulation property, water resistance, and aging resistance. A plurality of materials can be selected as the back sheet, generally including tempered glass, organic glass, aluminum alloy-Tedlar+Polyethylene terephthalate+Tedlar (TPT) composite adhesive film, etc., which can be specifically configured according to a specific condition and will not be limited herein. An assembly formed by the back sheet, the cells, the adhesive film, and the photovoltaic glass can be provided on the frame. The frame serves as a primary external support structure of an entire back contact cell module 100, so as to stably support and mount the back contact cell module 100. For example, the back contact cell module 100 can be mounted at a desired position through the frame.

### Embodiment 2

With reference to Fig. 1 and Fig. 2, in some optional embodiments, an included angle α between a first direction and a third direction satisfies the following relational expression: 0<tanα≤D/L, where

L is a total length between a distal point of a first cell and a distal point of a last cell in the cell string 200 in the first direction, and D is a width of any doped layer of the cells along the second direction.

In this way, an inclination angle of a ribbon can be obtained according to the length of the cell string 200. The angle can be adjusted for different lengths and different types of cell strings 200. Thus one ribbon can completely cover doped layers of a plurality of cells on a same line. In this way, process manufacturing can be facilitated. After the ribbon is connected in series to the plurality of cells, the cell strings 200 are selectively cut by laser to form pairs.

Specifically, according to the length of the cell strings 200 and the width of the doped layers, the inclination angle of the ribbon can be flexibly adjusted, so as to adapt to specific requirements of different cell strings 200 and guarantee that the ribbon can completely cover the doped layers. Then, by accurately calculating the included angle α, the ribbon can extend along a line when covering the doped layers, so as to improve efficiency and consistency of welding. One ribbon can completely cover doped layers of a plurality of cells on a process production line, simplifying a welding process, reducing welding steps and improving production efficiency. After connecting the plurality cells in series through the ribbon, the cell strings 200 are selectively cut by laser to form pairs. This method is efficient and accurate, reducing complexity of a production process.

Illustratively, the cell string 200 can have nine cells evenly distributed along the first direction. L is a distance between distal points of the nine cells. According to the length and the width of the doped layers in the second direction, the inclination angle α is calculated. Then the ribbon can be inclined at the angle α.

In the embodiment of the disclosure, a range of the included angle between the first direction and the third direction is not limited to satisfy different requirements. In this way, the included angle can be adjusted according to length of different cell strings 200 and the width of the doped layers in the second direction.

Further, the first doped layers 123 and the second doped layers 124 have equal widths in the second direction. In this way, the first doped layers 123 and the second doped layers 124 can be distributed, such that the ribbons can be uniformly provided on the rear side 12. Further, the ribbons can be provided on the corresponding doped layers after broken. The doped layers can be uniformly distributed, and the ribbons can uniformly cover the rear side 12, such that a current can be uniformly output.

Furthermore, center distances of two adjacent ribbons are equal in the second direction;
center distances of two adjacent doped layers are equal; and
the center distances of the two adjacent doped layers are equal to the center distances of the two adjacent ribbons.

In this way, after the doped layers are uniformly distributed on the rear sides 12 of the cells, the ribbons can also be uniformly distributed on the rear sides 12 of the cells. The center distance between adjacent ribbons is equal to the center distance between adjacent doped layers. Thus the ribbons and the doped layers can be accurately arranged correspondingly. Each of the doped layers can be effectively connected to the ribbon.

In the embodiments of the disclosure, the center distance between two adjacent ribbons is not limited to satisfy different requirements. For example, the center distance between two adjacent ribbons can be greater than or equal to 100 µm, and preferably, the center distance between two adjacent ribbons can be 300 µm

### Embodiment 3

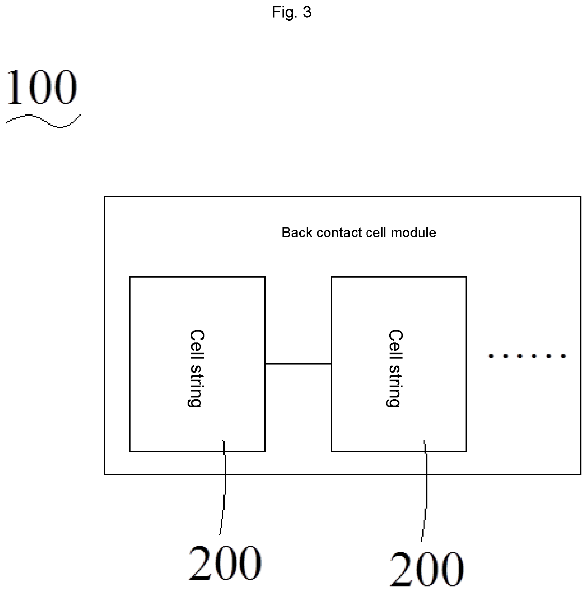

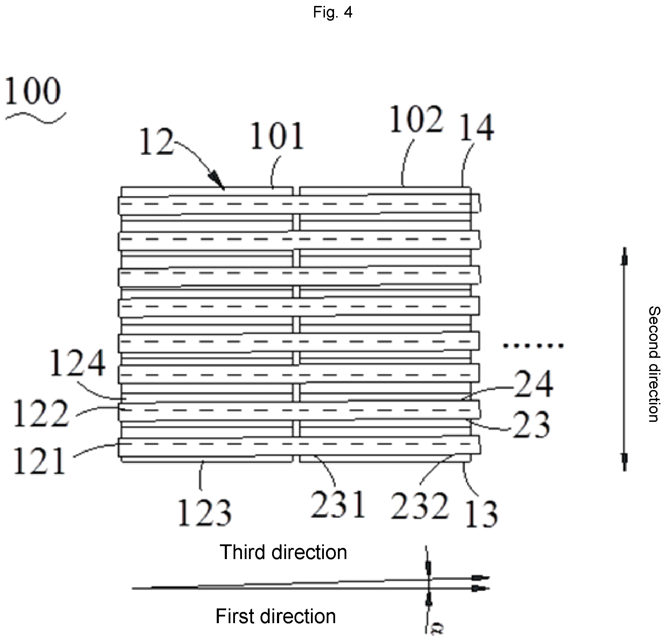

With reference to Fig. 3 and Fig. 4, in some optional embodiments, a rear side 12 is provided with first grid lines 121 and second grid lines 122. The first grid lines 121 and the second grid lines 122 extend along a first direction and are alternately distributed along a second direction. The first grid lines 121 are provided on first doped layers 123. The second grid lines 122 are provided on second doped layers 124. Each of the ribbons (not labeled in the figures) covers a first grid line 121 of each cell (not labeled in the figures) and a second grid line 122 of an adjacent cell.

In this way, the first doped layers 123 and the second doped layers 124 can output a current through the first grid lines 121 and the second grid lines 122, such that the current can be converged and electrically conducted through the ribbons.

Specifically, the first grid lines 121 and the second grid lines 122 are alternately distributed on the rear side 12 of the cell, so as to guarantee uniformity of current collection and conduction and reduce current loss. The first grid lines 121 are independently provided on the first doped layers 123. The second grid lines 122 are independently provided on the second doped layers 124. Thus interference of grid lines on a same doped layer is avoided, and current output efficiency is improved. The ribbons cover the first grid lines 121 and the second grid lines 122 of the adjacent battery cells. Current convergence between the plurality of cells is realized through the ribbons. Efficient current conduction is guaranteed.

Further, in process manufacturing of cell strings 200, each of the plurality of ribbons can cover grid lines of a plurality of cells on a same line at one time in a third direction. The welding efficiency is improved, and welding steps and time are reduced. Thus, the cell strings are suitable for mass production. The design that the ribbons are attached to the grid lines after being inclined at an angle facilitates the operation of automatic apparatuses and improves the accuracy and consistency of production. The connection between the ribbons to the grid lines increases mechanical strength and stability of the back contact cell module 100, and prolongs the service life.

Further, the gaps between the first grid lines 121 and the second grid lines 122 are flexibly adjusted according to actual requirements. The first grid lines 121 and the second grid lines 122 can be arranged at equal gaps, which can guarantee uniform current distribution and improve overall efficiency of the back contact cell module 100. Non-equal gaps can optimize current conduction paths for specific application scenarios and reduce local overheating or excessive resistance. Combination of some equal gaps and some non-equal gaps can combine the advantages of them and be flexibly adjusted according to specific requirements, so as to optimize performance of the back contact cell module 100.

Further, center distances of two adjacent grid lines are equal.

The center distances of the two adjacent grid lines are equal to center distances of two adjacent ribbons. In this way, after the grid lines are uniformly distributed on the rear sides 12 of the cells, the ribbons can also be uniformly distributed on the rear sides 12 of the cells. The center distance between adjacent ribbons is equal to the center distance between adjacent grid lines. Thus the ribbons and the grid lines can be accurately arranged correspondingly. Each of the grid lines can be effectively connected to the ribbon.

Moreover, in the embodiment of the disclosure, the center distances being equal means that a distance between structure centers of two adjacent structures is equal to a distance between structure centers of two other adjacent structures. The "equal" in process manufacturing can be to allow an error ratio between 0.9 and 1.1. That is, when a rated center distance is 1, a maximum error distance can be 1.1 times the rated distance, and a minimum error distance can be 0.9 time the rated distance.

Further, the plurality of ribbons are arranged in parallel.

The first grid lines 121, the second grid lines 122, the first doped layers 123 and the second doped layers 124 are all arranged in parallel.

In this way, the grid lines and the doped layers are arranged in parallel on the rear side 12 of the cell, such that the entire cell can be more regular. The plurality of ribbons are arranged in parallel on the rear side 12 of the cell and are evenly distributed along a direction perpendicular to the third direction. Thus it is guaranteed that the gaps between the ribbons are consistent to form a regular layout. Moreover, the ribbons can be arranged corresponding to the grid lines or the doped layers.

### Embodiment 4

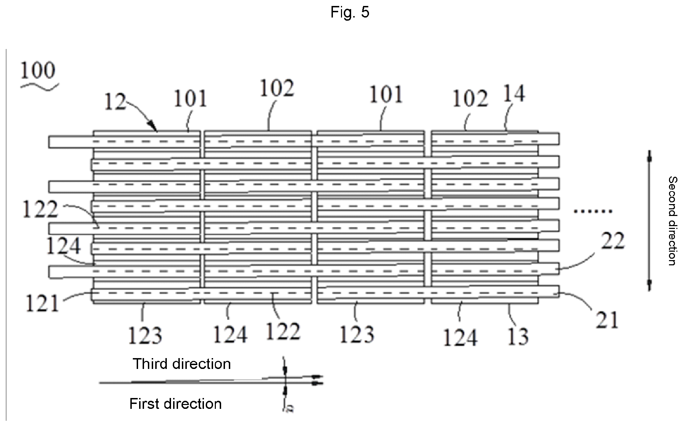

With reference to Fig. 4 and Fig. 5, in some optional embodiments, each of ribbons (not labeled in the figures) includes a first side 23 and a second side 24. The first side 23 and the second side 24 extend in a third direction. The first side 23 any cell includes a start section 231 and a tail section 232 on any of cells (not labeled in the figures). A distance between each of grid lines and the start section 231 is greater than a distance between the grid line and the tail section 232.

In this way, the ribbons are arranged in the third direction on each cell. A position of a first side 23 of each of the plurality of ribbons on any of the cells is different from that of the grid line, such that the ribbons can cover the grid lines and improve a connection ability to the grid lines.

Specifically, the ribbons are rectangular in shape. The first sides 23 and the second sides 24 are arranged in the third direction. The ribbons are arranged in the third direction, so as to guarantee that the ribbons cover the grid lines. Contact areas between the ribbons and the grid lines are increased. The current conduction efficiency is improved. The distances from the start section 231 and the tail section 232 of each of the plurality of ribbons to the grid line are different, such that optimal positions of the ribbons on the cells are guaranteed. The connection ability and stability of the ribbons and the grid lines are improved.

### Embodiment 5

With reference to Fig. 4 and Fig. 5, in some optional embodiments, each of the cells is rectangular in shape. The cells include first cells 101 and second cells 102 sequentially provided in a first direction. The cells include first edges 13 and second edges 14 distributed along a second direction. Gate lines of the first cells 101 closest to the first edges 13 are the first grid lines 121. Gate lines of the second cells 102 closest to the first edges 13 are the second grid lines 122. The grid lines of the first cells 101 and the second cells 102 in the first direction are located in the first sides 23 and the second sides 24.

In this way, it can be guaranteed that each of the grid lines is arranged in the ribbon and covered by the ribbon. In this case, polarities of grid lines on a same line between two adjacent cells are opposite, such that a ribbon can connect the first cell 101 and the second cell 102 in series.

Specifically, the cells are rectangular in shape, which is conducive to mass production and arrangement and improves space utilization. The cells have the first edges 13 and the second edges 14 distributed along the second direction, so as to facilitate proper arrangement of the grid lines and current collection.

In the embodiments of the disclosure, a shape of the cells is not limited to satisfy different requirements. For example, the cells can be rectangular or square monolithic cells. The square monolithic cells are then designed to correspond to single rectangular cells or single sub-cells after cutting (two sub-cells, three sub-cells, etc.). Main characteristic of such a cell is that a front side has no grid line and electrode structure, and positive and negative grid lines are alternately distributed on a rear side 12 of the cell in sequence. Moreover, in the embodiment of the disclosure, a number of the first grid lines 121, a number of the second grid lines 122, respective size ranges, and gaps between adjacent grid lines are not limited as long as the grid lines can be covered by the ribbons, to satisfy different requirements.

Illustratively, the first grid lines 121 can be positive electrodes, and the second grid lines 122 can be negative electrodes. Clearly, in other embodiments, the first grid lines 121 can be negative electrodes, and the second grid lines 122 can be positive electrodes, which are not limited herein. The alternating distribution of the first grid lines 121 and the second grid lines 122 and their precise connection to the ribbons enable a current to be collected and transmitted more efficiently. Electrical losses of fingers are reduced.

In some embodiments, the back contact cell module 100 further includes a convergence structure (not shown in the figures). The convergence structure can be connected to ribbons of a same polarity, to form a loop with cell strings 200 to output current energy. In the embodiment of the disclosure, a form of the convergence structure is not limited to satisfy different requirements. For example, the convergence structure can be a wire, a bus bar, or a conductive tape made of conductive material.

It can be understood that "first" and "second" in the first cells 101 and the second cells 102 are relative concepts, meaning that two back contact cells are different. For example, in the instance of Fig. 4, a left back contact cell is labeled as the first cell 101, and a right back contact cell is labeled as the second cell 102.

### Embodiment 6

With reference to Fig. 4 and Fig. 5, in some optional embodiments, each of ribbons is elongated in shape. A width of the ribbon is less than a gap between a first grid line 121 and a second grid line 122.

In this way, when the ribbon is provided on a cell, a problem of short circuit caused by that fact that one ribbon crosses two grid lines of one cell is avoided.

Specifically, the width of the ribbon is designed to be less than a distance between the first grid line 121 and the second grid line 122. It is guaranteed that two adjacent grid lines are not crossed and connected when the ribbon is arranged. By controlling the width of the ribbon, one ribbon is prevented from crossing two grid lines of one cell. Thus the problem of short circuit is prevented, and safe and stable operation of the cell is guaranteed.

### Embodiment 7

With reference to Fig. 4 and Fig. 5, in some optional embodiments, ribbons include first ribbons 21 and second ribbons 22. The first ribbons 21 and the second ribbons 22 extend in a third direction and are alternately distributed along a second direction.

Each of the first ribbons 21 covers and is connected to a first doped layer 123 or a first grid line 121 of a first cell 101. The first ribbon 21 further covers and is connected to a second doped layer 124 or a second grid line 122 of a second cell 102.

Each of the second ribbons 22 covers and is connected to a second doped layer 124 or a second grid line 122 of the first cell 101. The second ribbon 22 further covers and is connected to a first doped layer 123 or a first grid line 121 of another second cell 102.

In this way, the first ribbons 21 and the second ribbons 22 cooperate in sequence to connect the plurality of first cells 101 and the plurality of second cells 102 in series to form a cell string 200.

### Embodiment 8

With reference to Fig. 4 and Fig. 5, in some optional example, in each of cells, a distance between a start section 231 and a first edge 13 is less than a distance between a tail section 232 and the first edge 13.

In this way, a ribbon on the cell is arranged obliquely relative to the edge of the cell. The distances from the start section 231 and the tail section to the first edge 13 are different. The ribbon can cover a corresponding grid line to guarantee stable connection to the grid line.

Specifically, a start section 231 of a ribbon located on a same cell is closer to a first edge 13 of the cell, and a tail section 232 of the ribbon is farther from the first edge 13 of the cell. Such arrangement of the ribbon on the cell causes the ribbon to assume an inclined posture relative to the first edge 13 of the cell. The start section 231 and the tail section 232 of the ribbon cover the corresponding grid line, to guarantee stability of current conduction. Moreover, the inclined arrangement of the ribbon and the cell increases a contact area between the ribbon and the grid line, such that the stability and high efficiency of current conduction are guaranteed. The start section 231 and the tail section 232 of the ribbon cover the grid line, thus disconnection between the ribbon and the grid line is effectively prevented, and reliability of connection is improved. Moreover, the ribbon is obliquely arranged relative to the edge of the cell, such that a contact position of the ribbon and the grid line can be flexibly adjusted to adapt to cells of different types and sizes. The inclined ribbon can effectively disperse mechanical stress, reduce solder joint damage caused by stress concentration, and prolong the service life of the back contact cell module 100.

### Embodiment 9

With reference to Fig. 4 and Fig. 5, in some optional embodiments, a first edge 13 of each of cells is parallel to the doped layer or the grid line.

In this way, the first edge 13 and a second edge 14 of the cell can extend along a first direction, which is the same as an extension direction of a doped layer or a grid line. Thus the cell can be rectangular in shape, which is conductive to mass production and arrangement, and improves space utilization.

### Embodiment 10

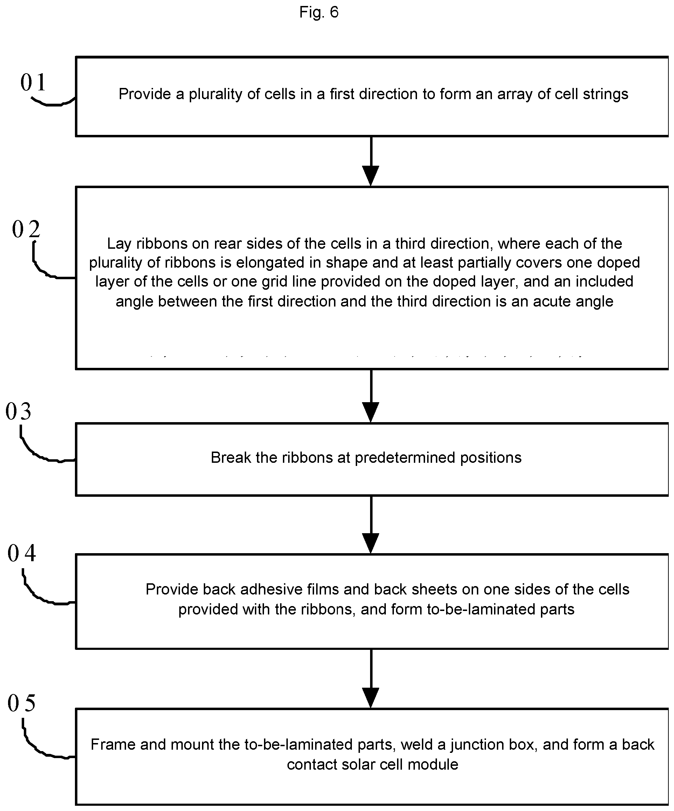

With reference to Fig. 1 and Fig. 6, the embodiments of the disclosure provide a manufacturing method for a back contact solar cell module 100. The manufacturing method includes:
01, a plurality of cells (not labeled in the figures) are provided in a first direction to form an array of cell strings 200;
02, ribbons (not labeled in the figures) are laid on rear sides 12 of the cells in a third direction, where each of the plurality of ribbons is elongated in shape and at least partially covers one doped layer of the cells or one grid line provided on the doped layer, and an included angle between the first direction and the third direction is an acute angle;
03, the ribbons are broken at predetermined positions;
04, back adhesive films and back sheets are provided on one sides of the cells provided with the ribbons, and to-be-laminated parts are formed; and
05, the to-be-laminated parts are framed and mounted, a junction box is welded, and a back contact solar cell module 100 is formed.

According to the back contact cell module 100 and the manufacturing method therefor provided in the embodiments of the disclosure, the back contact cell module 100 includes the cell strings 200 and the ribbons. The cell string 200 includes the plurality of cells. Each of the cells is provided with a front side and a rear side 12 that are opposite. The rear side 12 is provided with the first doped layers 123 and the second doped layers 124. The first doped layers 123 and the second doped layers 124 extend along the first direction and are alternately distributed along the second direction. The first direction intersects with the second direction. The ribbons are provided on at least two of the plurality of cells and electrically connected to the first doped layers 123 of the cell and the second doped layers 124 of the adjacent cell separately. The ribbons extend in the third direction and alternately distributed along the second direction. The included angle between the first direction and the third direction is an acute angle. Doping polarities of the first doped layers 123 and the second doped layers 124 are opposite. Accordingly, the ribbons and the doped layers can be arranged at acute angles, such that contact areas between the ribbons and the cells can be increased, electrical contact areas between the ribbons and the doped layer can be further increased, and electric conduction efficiency from the doped layers to the ribbons can be improved. Moreover, setting the ribbons obliquely can alleviate a problem of stress concentration, so as to guarantee stable connection between the ribbons and the cells.

Illustratively, a plurality of cells are placed on an assembly of a front sheet and a front adhesive film in the first direction, to form an array of battery cells 200. A number of the cells is not limited to achieve designs of the cell strings 200 with different numbers. An entire production line extends with the first direction as a reference. All the cells are laid with the front sides facing downwards and the rear sides 12 facing upwards. Step 02 is executed, and the ribbons are laid on the plurality of cells in the third direction. In this case, one ribbon can be connected to all the grid lines of the cells in a same line in the third direction. Then, the ribbon at predetermined positions is cut by laser cutting or other techniques, and the series-connected cell strings 200 are formed. The back adhesive films and the back sheets are provided on one sides of the cells provided with the ribbons, and the to-be-laminated parts are formed. Finally, the to-be-laminated parts are framed and mounted, the junction box is welded, and the back contact cell module 100 is formed.

Specifically, during process manufacturing, one ribbon can be simultaneously provided on the grid lines of a plurality of cells in the same line. Then the ribbon can be broken at the predetermined positions, to guarantee that the ribbon can be connected to the first grid line 121 and the second grid line 122 of adjacent cells. For example, the ribbon can be connected to a first grid line 121 of a first cell and a second grid line 122 of a second cell, and then disconnected at an end of the second grid line 122 of the second cell away from the first cell. Similarly, the ribbon can be connected to a first grid line 121 of the second cell and a second grid line 122 of the third cell, and then disconnected at an end of the second grid line 122 of the third cell away from the second cell. By analogy, the continuous cell strings 200 can be formed.

### Embodiment 11

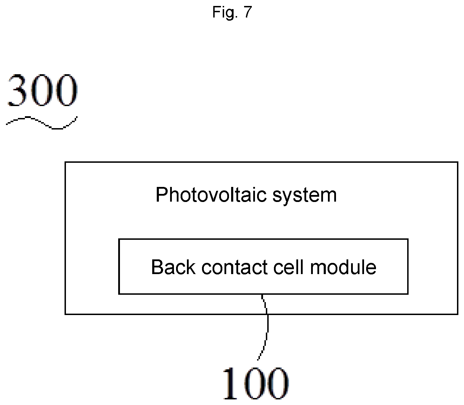

With reference to Fig. 1 and Fig. 7, a photovoltaic system 300 provided in the embodiments of the disclosure includes the back contact cell module 100 of any of the above embodiments.

According to the back contact cell module 100, the manufacturing method therefor and the photovoltaic system 300 provided in the embodiments of the disclosure, the back contact cell module 100 includes the cell strings 200 and the ribbons (not labeled in the figures). The cell string 200 includes the plurality of cells (not labeled in the figures). Each of the cells is provided with a front side and a rear side 12 that are opposite. The rear side 12 is provided with the first doped layers 123 and the second doped layers 124. The first doped layers 123 and the second doped layers 124 extend along the first direction and are alternately distributed along the second direction. The first direction intersects with the second direction. The ribbons are provided on at least two of the plurality of cells and electrically connected to the first doped layers 123 of the cell and the second doped layers 124 of the adjacent cell separately. The ribbons extend in the third direction and alternately distributed along the second direction. The included angle between the first direction and the third direction is an acute angle. Doping polarities of the first doped layers 123 and the second doped layers 124 are opposite. Accordingly, the ribbons and the doped layers can be arranged at acute angles, such that contact areas between the ribbons and the cells can be increased, electrical contact areas between the ribbons and the doped layer can be further increased, and electric conduction efficiency from the doped layers to the ribbons can be improved. Moreover, setting the ribbons obliquely can alleviate a problem of stress concentration, so as to guarantee stable connection between the ribbons and the cells.

In the example, the photovoltaic system 300 can be applied to photovoltaic power stations, such as a ground power station, a rooftop power station, and a water surface power station, and can also be applied to apparatuses or devices that generate power through solar energy, such as a solar power source of a user, a solar street lamp, a solar vehicle, and a solar building. Clearly, it can be understood that the application scenarios of the photovoltaic system 300 are not limited to the above. In other words, the photovoltaic system 300 can be applied to all fields for power generation through solar energy. With a photovoltaic power generation system network as an example, the photovoltaic system 300 can include a photovoltaic array, a bus box, and an inverter. The photovoltaic array can be an array combination of a plurality of back contact cell modules 100. For example, the plurality of back contact cell modules 100 can form a plurality of photovoltaic arrays, and the photovoltaic arrays are connected to the bus box. The bus box can combine currents generated through the photovoltaic arrays. The currents combined flow through the inverter to be converted into alternating currents required by a mains power grid and then are connected to the mains power grid to realize power supply through solar energy.

In the description, the descriptions with reference to the terms "some examples", "illustrative examples", "instances", "specific instances", or "some instances", etc., mean that a specific feature, structure, material, or characteristic described in connection with the examples or instances falls within at least one example or instance of the disclosure. In the description, the illustrative expressions of the above terms do not indicate the same examples or instances necessarily. Moreover, the specific feature, structure, material, or characteristic described can be combined in any one or more examples or instances in a suitable way.

Moreover, what are described above are merely preferred examples of the disclosure, and are not intended to limit the disclosure. Any modifications, equivalent replacements, improvements, etc. made within the spirit and principles of the disclosure should fall within the scope of protection of the disclosure.

## Claims

1. A back contact cell module, comprising:
a plurality of cell strings, each of the plurality of cell strings comprising a plurality of cells, wherein each of the cells comprises a front side and a rear side that are opposite, the rear side is provided with at least one first doped layer and at least one second doped layer, each of the at least one first doped layers and each of the at least one second doped layers extend along a first direction respectively and are alternately distributed along a second direction, and the first direction intersects with the second direction; and
a plurality of ribbons, wherein each of the plurality of ribbons is provided on at least two of the plurality of cells and electrically connected to the first doped layers of the cell and the second doped layers of an adjacent cell separately, each of the plurality of ribbons extends in a third direction and the ribbons alternately distributed in the second direction, and an included angle between the first direction and the third direction is an acute angle; and
a doping polarity of the first doped layers and a doping polarity of the second doped layers are opposite.

2. The back contact cell module according to claim 1, wherein the included angle α between the first direction and the third direction satisfies the following relational expression: 0<tanα≤D/L, wherein
L is a total length between a distal point of a first cell and a distal point of a last cell in the cell string along the first direction, and D is a width of any doped layer of the cells along the second direction.

3. The back contact cell module according to claim 1, wherein a width of each of the first doped layers in the second direction is equal to a width of each of the second doped layers in the second direction .

4. The back contact cell module according to claim 3, wherein center distances of two adjacent ribbons are equal in the second direction;
center distances of two adjacent doped layers are equal; and
the center distances of the two adjacent doped layers are equal to the center distances of the two adjacent ribbons.

5. The back contact cell module according to claim 1, wherein the rear side is provided with first grid lines and second grid lines, each of the first grid lines and each of the second grid lines extend along the first direction and are alternately distributed along the second direction, the first grid lines are provided on the first doped layers, the second grid lines are provided on the second doped layers, and each of the plurality of ribbons covers a first grid line of each cell and a second grid line of an adjacent cell.

6. The back contact cell module according to claim 5, wherein center distances of two adjacent grid lines are equal; and
the center distances of the two adjacent grid lines are equal to center distances of two adjacent ribbons.

7. The back contact cell module according to claim 5, wherein the plurality of the ribbons are in parallel; and
the first grid lines, the second grid lines, the first doped layers and the second doped layers are all in parallel.

8. The back contact cell module according to claim 5, wherein each of the plurality of ribbons comprises a first side and a second side, each of the first side and the second side extends in the third direction, the first side comprises a start section and a tail section on any of the cells, and a distance between each of the grid lines and the start section is greater than a distance between each of the grid line and the tail section.

9. The back contact cell module according to claim 8, wherein each of the cells is rectangular in shape, the cells comprise first cells and second cells sequentially provided in the first direction, each of the cells comprises a first edge and a second edge distributed along the second direction, grid lines of the first cells closest to the first edges are the first grid lines, and grid lines of the second cells closest to the first edges are the second grid lines.

10. The back contact cell module according to claim 9, wherein each of the plurality of ribbons is elongated in shape, and a width of the ribbon is less than a distance between the first grid line and the second grid line.

11. The back contact cell module according to claim 9, wherein the plurality of the ribbons comprise first ribbons and second ribbons, and each of the first ribbons and each of the second ribbons extend along the third direction and are alternately distributed along the second direction;
each of the first ribbons covers and is connected to the first doped layer or the first grid line of the first cell and the second doped layer or the second grid line of the second cell; and
each of the second ribbons covers and is connected to the second doped layer or the second grid line of the first cell and the first doped layer or the first grid line of another second cell.

12. The back contact cell module according to claim 9, wherein a distance between the start section and the first edge of each of the cells is less than a distance between the tail section and the first edge of each of the cell.

13. The back contact cell module according to claim 9 or 12, wherein the first edge of each of the cells is parallel to the doped layer or the grid line.

14. A manufacturing method for a back contact cell module, comprising:
providing a plurality of cells in a first direction to form an array of cell strings;
laying ribbons on rear sides of the cells in a third direction, wherein each of the plurality of ribbons is elongated in shape and at least partially covers one doped layer of the cells or one grid line provided on the doped layer, and an included angle between the first direction and the third direction is an acute angle;
breaking the ribbons at predetermined positions;
providing back adhesive films and back sheets on one sides of the cells provided with the ribbons, and forming to-be-laminated parts; and
framing and mounting the to-be-laminated parts, welding a junction box, and forming a back contact solar cell module.

15. A photovoltaic system, comprising the back contact cell module according to any one of claims 1 to 13.
